Europäisches Patentamt

European Patent Office

Office européen des brevets

(19)

(11) Publication number: **0 090 632**
**B1**

(12) **EUROPEAN PATENT SPECIFICATION**

(45) Date of publication of patent specification: **19.07.89**

(51) Int. Cl.⁴: **G 11 C 11/40**

(21) Application number: **83301734.6**

(22) Date of filing: **28.03.83**

(54) Static-type random-access memory device.

(30) Priority: **31.03.82 JP 51152/82**

(43) Date of publication of application:
**05.10.83 Bulletin 83/40**

(45) Publication of the grant of the patent:
**19.07.89 Bulletin 89/29**

(84) Designated Contracting States:
**DE FR GB**

(56) References cited:
**EP-A-0 045 133**
**US-A-4 075 690**

(73) Proprietor: **FUJITSU LIMITED**
**1015, Kamikodanaka Nakahara-ku**
**Kawasaki-shi Kanagawa 211 (JP)**

(72) Inventor: **Aoyama, Keizo**
**11-28 Tsukimino 1-chome**
**Yamato-shi Kanagawa 242 (JP)**
Inventor: **Yamauchi, Takahiko**
**Iseya-so 2F-1, 49, Kitaya-cho**
**Nakahara-ku Kawasaki-shi Kanagawa 211 (JP)**
Inventor: **Seki, Teruo**
**Dai-2 Yayoi-so 5 5-2, Shimo-shinjo 3-chome**
**Nakahara-ku Kawasaki-shi Kanagawa 211 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

Courier Press, Leamington Spa, England.

## Description

The present invention relates to a static-type random-access memory (RAM) device.

In a semiconductor memory device, the data stored in a memory cell thereof is sometimes destroyed owing to irradiation of the device by alpha rays or as a result of application of noise thereto. Such destruction of data occurs more frequently when the amplitude of the data stored in the memory cell, i.e. the voltage difference between the high level portion and the low level portion of each memory cell, is small.

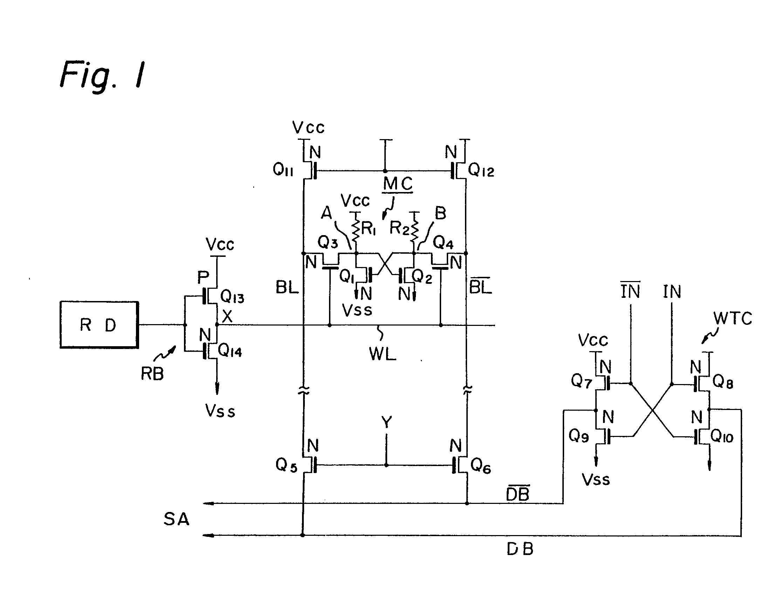

Figure 1 of the accompanying drawings shows a known static-type RAM device (hereinafter referred to as a static RAM device). In Figure 1, MC is a memory cell composed of four MIS transistors $Q_1$ through $Q_4$ and two resistors $R_1$ and $R_2$. BL and $\overline{BL}$ are bit lines, WL is a word line, and DB and $\overline{DB}$ are data buses. $Q_5$ and $Q_6$ are transistors constituting column-selecting transfer gates connected between the bit lines BL and $\overline{BL}$ and the data buses DB and $\overline{DB}$, respectively. $Q_{11}$ and $Q_{12}$ are load transistors connected between the bit lines BL and $\overline{BL}$ and a power source $V_{cc}$, and $Q_7$ through $Q_{10}$ are transistors constituting a write-in circuit WTC. RD is a row decoder, and RB is a row driver composed of transistors $Q_{13}$ and $Q_{14}$. One end of each of the data buses DB and $\overline{DB}$ is connected to a sense amplifier SA (not shown in the drawing). In Figure 1, only one memory cell MC, only one pair of bit lines BL and $\overline{BL}$, and only one word line WL are illustrated. In practice, however, a plurality of memory cells, bit line pairs, and word lines are provided.

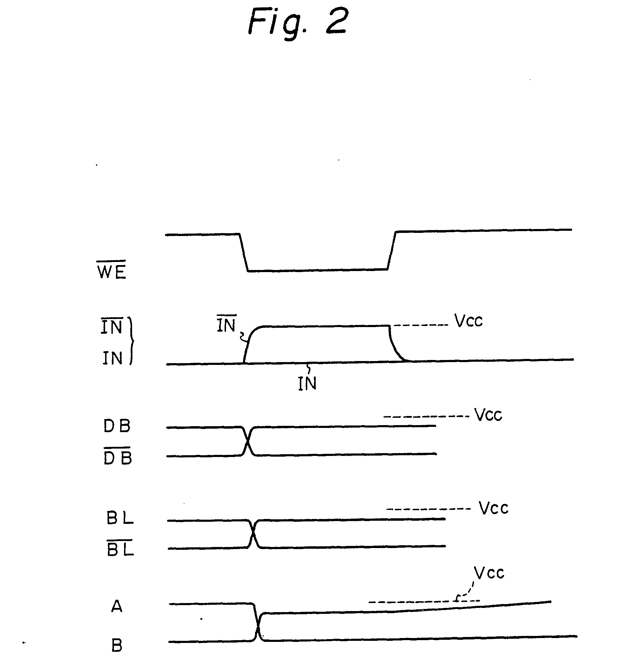

In the static RAM device of Figure 1, when data is written into the memory cell MC, a row-selecting signal X having a high potential level, which signal is obtained by inverting and amplifying the output of the row decoder RD, is applied to the word line WL, and a column-selecting signal Y having a high potential level is applied to the gate electrodes of the column-selecting transistors $Q_5$ and $Q_6$ by a column decoder (not shown). Thus, the transistors $Q_3$ and $Q_4$ of the memory cell MC and the column-selecting transistors $Q_5$ and $Q_6$ are all turned on, which causes the data buses DB and $\overline{DB}$ to be connected respectively to the bit lines BL and $\overline{BL}$, and the bit lines BL and $\overline{BL}$ to be connected respectively also to the nodes A and B of the memory cell MC. When the device is in this condition, a write-enable signal $\overline{WE}$ (Figure 2) is rendered low, and write-in signals IN and $\overline{IN}$ are rendered low and high, respectively, for example, and are applied to the write-in circuit WTC. Thus, the transistors $Q_7$ and $Q_{10}$ of the write-in circuit WTC are turned on and the transistors $Q_8$ and $Q_9$ thereof are turned off, thereby rendering the potentials of the data buses DB and $\overline{DB}$ high and low, respectively, and the potentials of the bit lines BL and $\overline{BL}$ high and low, respectively. Therefore, the transistor $Q_1$ of the memory cell MC is turned on and the transistor $Q_2$ of the memory cell MC is turned off, with the result that the potentials at the nodes A and B of the memory cell MC become low and high, respectively. Figure 2 of the accompanying drawings illustrates the waveforms of the signals at each node when an item of data "1" or "0" (which is opposite to the item of data "0" or "1" initially stored in the memory cell MC) is written into the memory cell MC.

The potential at the high level portion of the memory cell into which the information has just been written, i.e. the potential of the above-mentioned node B, is lower than the power supply voltage $V_{cc}$. As is illustrated in Figure 2, when the write-in signal $\overline{IN}$ changes from a low level potential to a high level potential which is approximately equal to the power supply voltage $V_{cc}$, the potential of the data bus $\overline{DB}$ rises from a low level potential to the potential $V_{cc}-V_{th}$ ($Q_7$), i.e. the potential which is attained by subtracting the threshold voltage $V_{th}$ ($Q_7$) of the transistor $Q_7$ from the power supply voltage $V_{cc}$. The potential of the bit line $\overline{BL}$ becomes $V_{cc}-V_{th}$ ($Q_6$) when the threshold voltage $V_{th}$ ($Q_6$) of the transistor $Q_6$ is larger than the threshold voltage $V_{th}$ ($Q_7$) and becomes $V_{cc}-V_{th}$ ($Q_7$) when $V_{th}$ ($Q_6$) is smaller than $V_{th}$ ($Q_7$). Therefore, the potential $V_B$ of the above-mentioned node B becomes

$$V_B = V_{cc} - V_{th} \ (Q_4, \ Q_6, \ Q_7)$$

where $V_{th}$ ($Q_4$, $Q_6$, $Q_7$) is the largest threshold voltage among the threshold voltages $V_{th}$ ($Q_4$), $V_{th}$ ($Q_6$), and $V_{th}$ ($Q_7$) of the transistors $Q_4$, $Q_6$, and $Q_7$, and it is assumed that the potentials of the high level signals of the word line WL, the write-in signals IN and $\overline{IN}$, and the column-selecting signal Y all rise to approximately the power supply voltage $V_{cc}$.

The potential $V_B$ of the node B, i.e. the node of the memory cell which is rendered—high by the above-mentioned write-in operation, rises toward the power supply voltage $V_{cc}$ with a time constant $R \cdot C$ after the write-in operation is finished due to the supply of electric charges through the load resistor $R_2$ of the memory cell. In this case, $R = R_1 = R_2$, and C is the stray capacitance of the node B. Recently, in static RAM devices, since the value of the resistance R is determined to be of the order of more than a gigohm in order to decrease power consumption, the time constant $R \cdot C$ is relatively large. Therefore, in the above-mentioned known—static RAM device, the time interval from the completion of the writing of data into the memory cell to the time when the potential of the high level portion of the memory cell is almost equal to the power supply voltage $V_{cc}$ becomes long. Thus, in such a known static RAM device, the stored data can frequently be destroyed by external noise, alpha rays, and so on which are applied to the memory cell during the above-mentioned time interval.

Accordingly, it is desirable to provide a static RAM device in which the likelihood that data stored in the memory cells will be destroyed as a result of alpha rays or noise is reduced.

According to the present invention there is provided a static-type RAM device comprising: a plurality of bit line pairs; a plurality of word lines; static-type memory cells located at respective points at which the bit lines cross the word lines and connected between first and second power supply lines of the device, the said first power supply line having a higher potential than the second when the device is in use; bit line selection means, connected to the said bit line pairs, for selecting one of those bit line pairs when data is to be written into a memory cell connected to that bit line pair; and word line selection means, connected to the said word lines, for selecting one of those word lines when data is to be written into a memory cell connected to that word line; characterised by first pull-up circuitry connected to the bit line pairs and operable, when a writing operation is performed to write data into a selected memory cell, to pull up the potential of one of the bit lines of the pair connected to the selected memory cell to a value which is not substantially less than the potential of the said first power supply line; and by second pull-up circuitry operable, upon termination of such a writing operation, to pull up the potential of the word line connected to the selected memory cell to a value which is not less than the potential of the said first power supply line and to maintain the potential of that word line at that value for a predetermined time interval.

In EP—A—0 045 133 a bootstrap circuit, which is suitable for use as a row or column decoder in a memory device, is disclosed, which is operable to provide an output signal which is higher in potential than that of the operating voltage. However, this document is not concerned with the same problems as the present application and there is no suggestion that the disclosed bootstrap circuit should, or could, be used to pull up the potential of a selected word line for a predetermined length of time after termination of a writing operation.

Reference will now be made, by way of example, to the accompanying drawings, in which:

Figure 1 is a block diagram illustrating a known MIS static-type RAM device;

Figure 2 is a waveform diagram illustrating the operation of the static-type RAM device of Figure 1;

Figure 3 is a block circuit diagram illustrating a MIS static-type RAM device embodying the present invention;

Figure 4 is a waveform diagram illustrating the operation of the static-type RAM device of Figure 3; and

Figures 5A and 5B are block circuit diagrams illustrating other embodiments of the present invention.

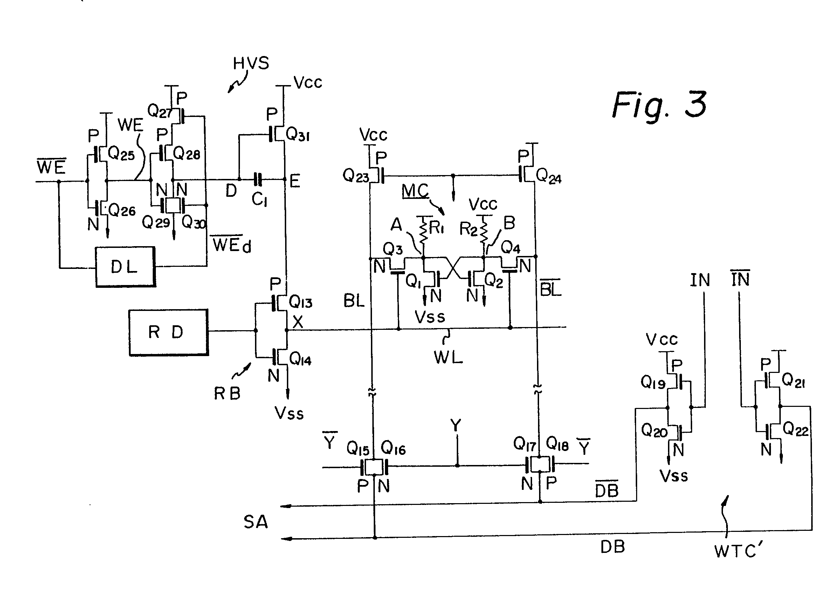

As shown in Figure 3, an MIS static-type RAM device embodying the present invention differs from the device of Figure 1 in that, in the RAM device of Figure 3, there is provided a high-voltage supplying circuit HVS which supplies a power source to row drivers RB connected to row decoders. The device of Figure 3 also differs in that transfer gates for selecting a column, which are connected between bit lines BL, $\overline{BL}$ and data buses DB, $\overline{DB}$, comprise a P-type transistor $Q_{15}$ and an N-type transistor $Q_{16}$ connected together in parallel and a P-type transistor $Q_{18}$ and an N-type transistor $Q_{17}$ connected together in parallel; in that load transistors $Q_{23}$ and $Q_{24}$ of the bit lines BL and $\overline{BL}$ are P-type transistors; and in that a write-in circuit WTC′ comprises complementary metal-insulator semiconductor (MIS)-type inverters. The high voltage supplying circuit HVS comprises transistors $Q_{25}$ through $Q_{31}$, a capacitor $C_1$, and a delay circuit DL.

Incidentally, a static memory device having a write-in circuit comprising a CMIS inverter, operable to apply signals to data buses, and transmission gates, each comprising a P-type and an N-type transistor connected together in parallel, connecting the data buses to respective bit lines is disclosed in US—A—4,075,690, but this prior art document does not disclose any form of pull-up circuitry for the word lines, not does it address the same problems as the present application.

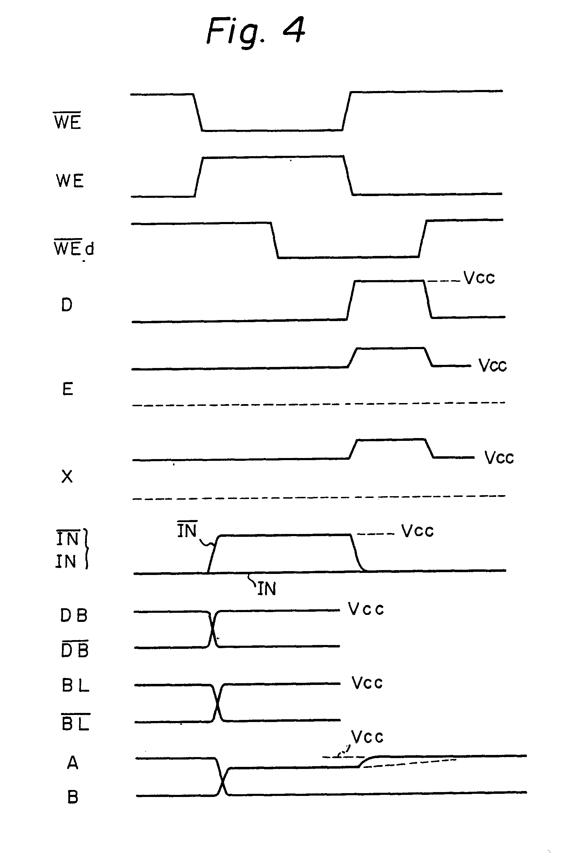

In the static-type RAM device of Figure 3, when data is to be written into a memory cell MC in a writing operation, a row-selecting signal X, having a high potential level and which is an inverted signal of the output of a row decoder RD, is applied to a word line WL. At the same time, a column-selecting signal Y having a high potential level is applied to the N-type MIS transistors $Q_{16}$ and $Q_{17}$ and an inverted signal $\overline{Y}$ of the column-selecting signal Y is applied to the P-type transistors $Q_{15}$ and $Q_{18}$ in order to turn on the transfer gates so that a column is selected by a column decoder, etc. (not shown). The writing operation is delimited by the falling and rising of an inverted write-enable signal ($\overline{WE}$). When the inverted write-enable signal $\overline{WE}$ is rendered low, write-in signals IN and $\overline{IN}$ are rendered low and high, respectively, and are applied to the write-in circuit WTC′. Accordingly, the P-type transistor $Q_{19}$ is turned on by the write-in signal IN, which has a low potential level, and the potential of the data bus $\overline{DB}$ is pulled up to approximately the power supply voltage $V_{cc}$, as is illustrated in Figure 4. Since each of the transfer gates for selecting columns comprises a P-type transistor and an N-type transistor—connected together in parallel, and since each of the load transistors $Q_{23}$ and $Q_{24}$ is a P-type transistor, the potential of the bit line $\overline{BL}$ is also pulled up to approximately the power supply voltage $V_{cc}$.

The inverted write-enable signal $\overline{WE}$ is applied to the high-voltage supplying circuit HVS and is inverted by a CMIS inverter comprising the transistors $Q_{25}$ and $Q_{26}$, and thereby the write-enable signal WE is produced and applied to the transistors $Q_{28}$ and $Q_{29}$. The inverted write-enable signal $\overline{WE}$ is delayed for a predetermined length of time by the delay circuit DL, which outputs a delayed signal $\overline{WE}_d$ which is applied to the transistors $Q_{27}$ and $Q_{30}$. The transistors $Q_{27}$ through $Q_{30}$ constitute a NOR gate whose output (point D) becomes high only when both the write-enable signal WE and the delayed signal $\overline{WE}_d$ are low, because the transistors $Q_{27}$ and $Q_{28}$ are turned on and the transistors $Q_{29}$ and $Q_{30}$ are turned off in this condition. Therefore, when the inverted write-enable signal $\overline{WE}$ becomes high again, a pulse signal is generated at the point D, which has a time width corresponding to the delay time of the delay circuit DL. The transistor $Q_{31}$ is turned on when the potential of the point D is low and charges the capacitor $C_1$ so that the potential difference between the terminals of the capacitor $C_1$ becomes approximately $V_{cc}$. Therefore, when the potential of the point D becomes high, the transistor $Q_{31}$ is turned off and a voltage, which is the sum of the potential of the point D and the voltage charged into the capacitor $C_1$, i.e. a voltage which is higher than or equal to the power supply voltage $V_{cc}$, is generated at a point E and is supplied to the row driver RB. Consequently, the potential X of the word line WL is temporarily pulled up to a potential level which is higher than or equal to the power supply voltage $V_{cc}$ after the writing in of data is completed. In this condition, since the potential of the bit line $\overline{BL}$ is pulled up to approximately the power supply voltage $V_{cc}$, as was mentioned before, the potential of the node B in the memory cell MC is rapidly pulled up to approximately the power supply voltage $V_{cc}$ after the writing in of data is completed, thereby decreasing the possibility of destruction of the stored data by external noise and so on.

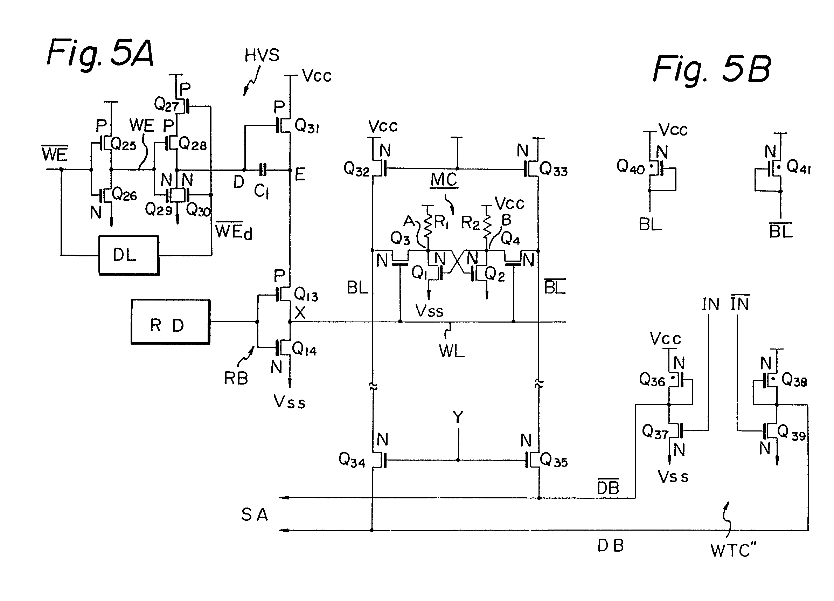

Figure 5A illustrates another MIS static-type RAM device embodying the present invention. In the static-type RAM device of Figure 5A, load transistors $Q_{32}$ and $Q_{33}$ of the bit lines BL and $\overline{BL}$, and transistors $Q_{34}$ and $Q_{35}$ of the transfer gates for selecting a column, are each constituted by N-type transistors having a smaller threshold voltage than other enhancement transistors used in the RAM device, and a write-in circuit WTC'' comprises two inverter circuits each having a depletion-type load transistor $Q_{36}$ or $Q_{38}$, thereby pulling up the potential of the high level voltage of a bit line to approximately the power supply voltage $V_{cc}$. The other portions of the device of Figure 5A are the same as those of Figure 3.

It is also possible to replace the load transistors $Q_{32}$ and $Q_{33}$ of the bit lines BL and $\overline{BL}$ shown in Figure 5A with depletion-type transistors $Q_{40}$ and $Q_{41}$, as is illustrated in Figure 5B.

As was mentioned above, in an embodiment of the present invention, since the potential of the high level point of a memory cell is pulled up to approximately the power supply voltage $V_{cc}$ just after the writing in of data is completed, the possibility of the destruction of stored data in each memory cell by external noise, the irradiation of alpha rays, and so on is decreased, thereby making it possible to obtain a memory device having a higher reliability than known static-type RAM devices.

## Claims

1. A static-type RAM device comprising:
a plurality of bit line pairs (BL, $\overline{BL}$);
a plurality of word lines (WL);
static-type memory cells (MC) located at respective points at which the bit lines (BL, $\overline{BL}$) cross the word lines (WL) and connected between first and second power supply lines ($V_{cc}$, $V_{ss}$) of the device, the said first power supply line ($V_{cc}$) having a higher potential than the second when the device is in use;
bit line selection means, connected to the said bit line pairs (BL, $\overline{BL}$), for selecting one of those bit line pairs (BL, $\overline{BL}$) when data is to be written into a memory cell (MC) connected to that bit line pair; and
word line selection means (RD), connected to the said word lines (WL), for selecting one of those word lines (WL) when data is to be written into a memory cell (MC) connected to that word line;
characterised by first pull-up circuit ($Q_{15}$ to $Q_{22}$) connected to the bit line pairs (BL, $\overline{BL}$) and operable, when a writing operation is performed to write data into a selected memory cell (MC), to pull up the potential of one of the bit lines (BL, $\overline{BL}$) of the pair connected to the selected memory cell (MC) to a value which is not substantially less than the potential of the said first power supply line ($V_{cc}$); and by second pull-up circuitry (HVS) operable, upon termination of such a writing operation, to pull up the potential of the word line (WL) connected to the selected memory cell (MC) to a value which is not less than the potential of the said first power supply line ($V_{cc}$) and to maintain the potential of that word line (WL) at that value for a predetermined time interval.

2. A device as claimed in claim 1, wherein the said first pull-up circuitry ($Q_{15}$ to $Q_{22}$) comprises transfer gates ($Q_{15}$, $Q_{16}$, $Q_{17}$, $Q_{18}$) operable to transfer respective signals to the bit lines (BL, $\overline{BL}$) connected to a selected memory cell (MC), when a writing operation is performed, each of the said transfer gates ($Q_{15}$, $Q_{16}$, $Q_{17}$, $Q_{18}$) comprising a P-type MIS transistor ($Q_{15}$, $Q_{18}$) and an N-type MIS transistor ($Q_{16}$, $Q_{17}$) connected together in parallel between a bit line (BL, $\overline{BL}$) and a data bus (DB, $\overline{DB}$) of the device.

3. A device as claimed in claim 2, wherein the said first pull-up circuitry ($Q_{15}$ to $Q_{22}$) further comprises write-in circuitry (WTC') including CMIS-type inverters ($Q_{19}/Q_{20}$; $Q_{21}/Q_{22}$) connected to receive respective selection signals (IN, $\overline{IN}$) and to apply respective output signals to respective data buses (DB, $\overline{DB}$) of the device.

4. A device as claimed in claim 1, 2 or 3, wherein the said first pull-up circuitry ($Q_{15}$ to $Q_{24}$) comprises P-type MIS load transistors ($Q_{23}$, $Q_{24}$) having respective drains or sources connected to the said first power supply line ($V_{cc}$), respective sources or drains connected to respective bit lines (BL, $\overline{BL}$), and respective gates connected to the said second power supply line ($V_{ss}$).

5. A device as claimed in claim 1, wherein the said first pull-up circuitry ($Q_{34}$ to $Q_{39}$) comprises transfer gates ($Q_{34}$, $Q_{35}$) operable to transfer respective signals to the bit lines (BL, $\overline{BL}$) connected to a selected memory cell (MC), when a writing operation is performed, each of the said transfer gates comprising an enhancement-type MIS transistor ($Q_{34}$, $Q_{35}$), having a smaller threshold voltage than that of other enhancement-type transistors in the said device, connected between a bit line (BL, $\overline{BL}$) and a data bus (DB, $\overline{DB}$) of the device.

6. A device as claimed in claim 5, wherein the said first pull-up circuitry ($Q_{34}$ to $Q_{39}$) further comprises write-in circuitry (WTC'') including CMIS-type inverters ($Q_{36}/Q_{37}$; $Q_{38}/Q_{39}$) connected to receive respective selection signals (IN, $\overline{IN}$) and to apply respective output signals to respective data buses (DB, $\overline{DB}$) of the device, each of the said CMIS-type inverters ($Q_{36}/Q_{37}$; $Q_{38}/Q_{39}$) comprising an inverter transistor ($Q_{37}$, $Q_{39}$) and a depletion-type load transistor ($Q_{36}$, $Q_{38}$).

7. A device as claimed in claim 1, 5 or 6, wherein the said first pull-up circuitry ($Q_{34}$ to $Q_{41}$) comprises depletion-type MIS load transistors ($Q_{40}$, $Q_{41}$) having respective drains or sources connected to the said first power supply line ($V_{cc}$) and respective gates and sources, or respective gates and drains, connected to respective bit lines (BL, $\overline{BL}$).

8. A device as claimed in any preceding claim, further comprising row address driver circuitry (RB) connected to the said word lines (WL) and having a power supply terminal connected to the said second pull-up circuitry (HVS), the said power supply terminal being pulled up by the said second pull-up circuitry (HVS) when that pull-up circuitry is in operation.

9. A device as claimed in claim 8, wherein the said second pull-up circuitry (HVS) comprises:

delay circuitry (DL) having an input terminal to which a control signal pulse ($\overline{WE}$) is applied when a writing operation is to be performed, the delay circuitry being operable to produce a delayed control signal pulse ($\overline{WE}_d$) upon the elapse of a predetermined delay time from the time of receipt of the said control signal pulse ($\overline{WE}$);

gate circuitry ($Q_{27}$ to $Q_{30}$) connected to receive the said delayed control signal pulse ($\overline{WE}_d$) and operable, when application of the said control signal pulse ($\overline{WE}$) to the said delay circuitry (DL) has terminated, to produce an activating signal pulse which is equal in length to the said delay time; and

bootstrap circuitry ($Q_{31}$, $C_1$) connected to receive the said activating signal pulse and operable, in response thereto, to produce an output signal pulse having a potential which is not less than the potential of the said first power supply line ($V_{cc}$), the length of the said output signal pulse being equal to the said delay time.

10. A device as claimed in claim 9, wherein the said second pull-up circuitry (HVS) further comprises inverter circuitry ($Q_{25}$, $Q_{26}$), to which the said control signal pulse ($\overline{WE}$) is applied, for inverting the said control signal pulse ($\overline{WE}$) and applying that inverted pulse (WE) to the said gate circuitry ($Q_{27}$ to $Q_{30}$).

11. A device as claimed in claim 10, wherein the said control signal pulse ($\overline{WE}$) is an inverted write-enable signal pulse ($\overline{WE}$) and the said gate circuitry ($Q_{27}$ to $Q_{30}$) comprises a NOR gate connected to receive the delayed inverted write-enable signal ($\overline{WE}_d$) from the said delay circuitry (DL) and the non-inverted write-enable signal (WE) from the said inverter circuitry ($Q_{25}$, $Q_{26}$).

12. A device as claimed in any one of claims 9 to 11, wherein the said bootstrap circuitry ($Q_{31}$, $C_1$) comprises an MIS transistor ($Q_{31}$), having its drain and source connected between the said first power supply line ($V_{cc}$) and the said power supply terminal of the row address driver circuitry (RB) and having its gate connected to receive the said activating signal pulse, and a capacitor ($C_1$) connected between the said gate and drain of the said transistor ($Q_{31}$).

**Patentansprüche**

1. Statische RAM-Vorrichtung mit:
einer Vielzahl von Bitleitungspaaren (BL, $\overline{BL}$);
einer Vielzahl von Wortleitungen (WL);
statischen Speicherzellen (MC), die jeweils an Punkten angeordnet sind, an welchen die Bitleitungen (BL, $\overline{BL}$) die Wortleitungen (WL) kreuzen, und zwischen ersten und zweiten Energieversorgungsleitungen ($V_{cc}$, $V_{ss}$) der Vorrichtung verbunden sind, wobei die erste Energieversorgungsleitung ($V_{cc}$) ein höheres Potential als die zweite hat, wenn die Vorrichtung in Betrieb ist;

Bitleitungsauswahleinrichtungen, die mit den genannten Bitleitungspaaren (BL, $\overline{BL}$) verbunden sind, um eines von jenen Bitleitungspaaren (BL, $\overline{BL}$) auszuwählen, wenn Daten in eine Speicherzelle (MC) geschrieben werden sollen, die mit jenem Bitleitungspaar verbunden ist, und

Wortleitungsauswahleinrichtungen (RD), die mit den genannten Wortleitungen (WL) verbunden sind, um eine jener Wortleitungen (WL) auszuwählen, wenn Daten in eine Speicherzelle (MC), die mit jener Wortleitung verbunden ist, geschrieben werden sollen;

gekennzeichnet durch eine erste pull-up-Schaltung ($Q_{15}$ bis $Q_{22}$), die mit den Bitleitungspaaren (BL, $\overline{BL}$) verbunden und betreibbar ist, wenn ein Schreib- betrieb durchgeführt wird, um Daten in einer ausgewählte Speicherzelle (MC) zu schreiben, um das Potential dre einen der Bitleitungen (BL, $\overline{BL}$) des Paares, welches mit der ausgewählten Speicherzelle (MC) verbunden ist, auf einen Wert hochzuziehen, der nicht wesentlich kleiner als das Potential der genannten ersten Energieversorgungsleitung ($V_{cc}$) ist; und durch eine zweite pull-up-Schaltung (HVS), die bei Beendigung solch eines Schreibbetriebs betreibbar ist, um das Potential der Wortleitung (WL), die mit der ausgewählten Speicherzelle (MC) verbunden ist, auf einen Wert hochzuziehen, der nicht kleiner als das Potential der ersten Energieversor-

gungsleitung (V$_{cc}$) ist, und um das Potential von jener Wortleitung (WL) für ein vorbestimmtes Zeitintervall auf jenem Wert zu halten.

2. Vorrichtung nach Anspruch 1, bei der die genannte erste pull-up-Schaltung (Q$_{15}$ bis Q$_{22}$) erste Transfergates (Q$_{15}$, Q$_{16}$, Q$_{17}$, Q$_{18}$) umfaßt, die betreibbar sind, um entsprechende Signale zu den Bitleitungen (BL, $\overline{BL}$) zu übertragen, die mit einer ausgewählten Speicherzelle (MC) verbunden sind, wenn ein Schreibbetrieb ausgeführt wird, wobei jedes der genannten Transfergates (Q$_{15}$, Q$_{16}$, Q$_{17}$, Q$_{18}$) einen p-Typ-MIS-Transistor (Q$_{15}$, Q$_{18}$), und einen N-Typ-MIS-Transistor (Q$_{16}$, Q$_{17}$) umfaßt, die parallel zueinander zwischen einer Bitleitung (BL, $\overline{BL}$) und einem Datenbus (DB, $\overline{DB}$) der Vorrichtung verbunden sind.

3. Vorrichtung nach Anspruch 2, bei der die genannte erste pull-up-Schaltung (Q$_{15}$ bis Q$_{22}$) ferner eine Einschreibschaltung (WTC') umfaßt, welche CMIS-Typ-Inverter (Q$_{19}$/Q$_{20}$; Q$_{21}$/Q$_{22}$) umfaßt, die angeschlossen sind, um entsprechende Auswahlsignale (IN, $\overline{IN}$) zu empfangen und entsprechende Ausgangssignale auf entsprechende Datenbusse (DB, $\overline{DB}$) der Vorrichtung aufzubringen.

4. Vorrichtung nach Anspruch 1, 2 oder 3, bei der die genannte erste pull-up-Schaltung (Q$_{15}$ bis Q$_{24}$) p-Typ-MIS-Lasttransistoren (Q$_{23}$, Q$_{24}$) umfaßt, die jeweilige Drains und Sourcen haben, die mit der genannten ersten Energieversorgungsleitung (V$_{cc}$) verbunden sind, und entsprechende Sourcen oder Drains, die mit entsprechenden Bitleitungen (BL, $\overline{BL}$) verbunden sind, und entsprechende Gates, dit mit der genannten zweiten Energieversorgungsleitung (V$_{ss}$) verbunden sind.

5. Vorrichtung nach Anspruch 1, bei der die genannte erste pull-up-Schaltung (Q$_{34}$ bis Q$_{39}$) Transfergates (Q$_{34}$, Q$_{35}$) umfaßt, die betreibbar sind, um entsprechende Signale zu den Bitleitungen (BL, $\overline{BL}$) zu übertragen, welche mit einer ausgewählten Speicherzelle (MC) verbunden sind, wenn ein Schreibbetrieb durchgeführt wird, wobei jedes der Transfergates einen Anreicherungstyp-MIS-Transistor (Q$_{34}$, Q$_{35}$) umfaßt, der eine kleinere Schwellenwertspannung als diejenige des anderen Anreicherungstyptransistors in der genannten Vorrichtung hat, welcher zwischen einer Bitleitung (BL, $\overline{BL}$) und einem Datenbus (DB, $\overline{DB}$) der Vorrichtung verbunden ist.

6. Vorrichtung nach Anspruch 5, bei der die genannte erste pull-up-Schaltung (Q$_{34}$ bis Q$_{39}$) ferner eine Einschreibschaltung (WTC'') umfaßt, die CMIS-Typ-Inverter (Q$_{36}$/Q$_{37}$; Q$_{38}$/Q$_{39}$) umfaßt, die angeschlossen sind, um entsprechende Auswahlsignale (IN, $\overline{IN}$) zu empfangen und um entsprechende Ausgangssignale auf entsprechende Datenbusse (DB, $\overline{DB}$) der Vorrichtung aufzubringen, wobei jeder der genannten CMIS-Typ-Inverter (Q$_{36}$/Q$_{37}$; Q$_{38}$/Q$_{39}$) einen Invertertransistor (Q$_{37}$, Q$_{39}$) und einen Verarmungstyp-Lasttransistor (Q$_{36}$, Q$_{38}$) umfaßt.

7. Vorrichtung nach Anspruch 1, 5 oder 6, bei der die genannte erste pull-up-Schaltung (Q$_{34}$ bis Q$_{41}$) Verarmungstyp-MIS-Lasttransistoren (Q$_{40}$, Q$_{41}$) umfaßt, die jeweils Drains oder Sourcen haben, die mit der genannten ersten Energieversorgungsleitung (V$_{cc}$) verbunden sind, und entsprechenden Gates und Sourcen oder entsprechende Gates und Drains, die mit entsprechenden Bitleitungen (BL, $\overline{BL}$) verbunden sind.

8. Vorrichtung nach einem der vorhergehenden Ansprüche, ferner mit einer Reihenadresstreiberschaltung (RB), die mit den genannten Wortleitungen (WL) verbunden ist und einen Energieversorgungsanschluß hat, der mit der genannten zweiten pull-up-Schaltung (HVS) verbunden ist, wobei der genannte Energieversorgungsanschluß durch die genannte zweite pull-up-Schaltung (HVS) hochgezogen wird, wenn diese pull-up-Schaltung in Betrieb ist.

9. Vorrichtung nach Anspruch 8, bei der die zweite pull-up-Schaltung (HVS) umfaßt:

eine Verzögerungsschaltung (DL), die einen Eingangsanschluß hat, auf den ein Steuersignalimpuls ($\overline{WE}$) aufgebracht wird, wenn ein Schreibbetrieb durchgeführt werden soll, bei der die Verzögerungsschaltung betreibbar ist, um einen verzögerten Steuersignalimpuls ($\overline{WE}_d$) beim Ablauf einer vorbestimmten Verzögerungszeit von der Zeit des Empfangs des genannten Steuersignalimpulses ($\overline{WE}$) zu erzeugen;

eine Gateschaltung (Q$_{27}$ bis Q$_{30}$), die angeschlossen ist, um den genannten verzögerten Steuersignalimpuls ($\overline{WE}_d$) zu empfangen, und betriebbar ist, wenn die Aufbringung des genannten Steuersignalimpulses ($\overline{WE}$) auf die genannte Verzögerungsschaltung (DL) beendet worden ist, um einen Aktivierungssignalimpuls zu erzeugen, dessen Länge gleich der genannten Verzögerungszeit ist; und

eine Bootstrap-Schaltung (Q$_{31}$, C$_1$), die angeschlossen ist, um den genannten Aktivierungssignalimpuls zu empfangen, und, ansprechend darauf, betreibbar ist, um einen Ausgangssignalimpuls zu erzeugen, der ein Potential hat, das nicht kleiner als das Potential der genannten ersten Energieversorgungsleitung (V$_{cc}$) ist, wobei die Länge des genannten Ausgangssignalimpulses gleich der genannten Verzögerungszeit ist.

10. Vorrichtung nach Anspruch 9, bei der die genannte zweite pull-up-Schaltung (HVS) ferner eine Inverterschaltung (Q$_{25}$, Q$_{26}$) umfaßt, auf welche der genannte Steuersignalimpuls ($\overline{WE}$) aufgebracht wird, um den genannten Steuersignalimpuls ($\overline{WE}$) zu invertieren und jenen invertierten Impuls (WE) auf die genannte Gateschaltung (Q$_{27}$ bis Q$_{30}$) aufzubringen.

11. Vorrichtung nach Anspruch 10, bei der der genannte Steuersignalimpuls ($\overline{WE}$) ein invertierter Schreibfreigabesignalimpuls ($\overline{WE}$) ist und die genannte Gateschaltung (Q$_{27}$ bis Q$_{30}$) ein NOR-Gatter umfaßt, welches angeschlossen ist, um das verzögerte invertierte Schreibfreigabesignal ($\overline{WE}_d$) von der genannten Verzögerungsschaltung (DL) und das nichtinvertierte Schreibfreigabesignal (WE) von der genannten Inverterschaltung (Q$_{25}$, Q$_{26}$) zu empfangen.

12. Vorrichtung nach einem der Ansprüche 9 bis 11, bei der die genannte Bootstrap-Schaltung

(Q$_{31}$, C$_1$) einen MIS-Transistor (Q$_{31}$) umfaßt, dessen Drain und Source zwischen der genannten ersten Energieversorgungsleitung (V$_{cc}$) und dem genannten Energieversorgungsanschluß der Reihenadreßtreiberschaltung verbunden sind, und dessen Gate verbunden ist, um den genannten Aktivierungssignalimpuls zu empfangen, und einen Kondensator (C$_1$), der zwischen dem genannten Gate und Drain des genannten Transistors (Q$_{31}$) verbunden ist.

## Revendications

1. Dispositif de mémoire à accès sélectif RAM du type statique comprenant:

un ensemble de paires de fils de bit (BL,$\overline{BL}$);

un ensemble de fils de mot (WL);

des cellules de mémoire du type statique (MC) placées à des points respectifs où les fils de bit (BL, $\overline{BL}$) coupent les fils de mot (WL) et connectées entre des premier et deuxième fils de tension d'alimentation (V$_{cc}$, V$_{ss}$) du dispositif, le premier fil de tension d'alimentation (V$_{cc}$) ayant un potentiel supérieur à celui du deuxième fil quand le dispositif est utilisé;

un moyen de sélection de fil de bit, connecté aux paires de fils de bit (BL,$\overline{BL}$), pour sélectionner une des paires de fils de bit (BL,$\overline{BL}$) quand une donnée doit être écrite dans une cellule de mémoire (MC) connectée à cette paire de fils de bit; et

un moyen de sélection de fil de mot (RD), connecté aux fils de mot (WL), pour sélectionner un des fils de mot (WL) quand une donnée doit être écrite dans une cellule de mémoire (MC) connectée à ce fil de mot;

caractérisé par des premiers circuits élévateurs (Q$_{15}$ à Q$_{22}$) connectés aux paires de fils de bit (BL, $\overline{BL}$) et pouvant être mis en fonctionnement, quand une opération d'écriture est exécutée pour écrire une donnée dans une cellule de mémoire sélectionnée (MC), pour élever le potentiel d'un des fils de bit (BL,$\overline{BL}$) de la paire connectée à la cellule de mémoire sélectionnée (MC) à une valeur qui n'est pas substantiellement inférieure au potentiel du premier fil de tension d'alimentation (V$_{cc}$); et par des deuxièmes circuits élevateurs (HVS) pouvant être mis en fonctionnement, à la fin de cette opération d'écriture, pour élever le potentiel du fil de mot (WL) connecté à la cellule de mémoire sélectionnée (MC) à une valeur qui n'est pas inférieure au potentiel du premier fil de tension d'alimentation (V$_{cc}$) et pour maintenir le potentiel de ce fil de mot (WL) à cette valeur pendant un intervalle de temps prédéterminée.

2. Dispositif selon la revendication 1, dans lequel les premiers circuits élevateurs (Q$_{15}$ à Q$_{22}$) comprennent des portes de transfert (Q$_{15}$, Q$_{16}$, Q$_{17}$, Q$_{18}$ pouvant être mises en fonctionnement pour transférer des signaux respectifs jusqu'aux fils de bit (BL, $\overline{BL}$) connectés à une cellule de mémoire sélectionnée (MC), quand une opération d'écriture est exécutée, chacune des portes de transfert (Q$_{15}$, Q$_{16}$, Q$_{17}$, Q$_{18}$) comprenant un transistor MIS du type P (Q$_{15}$, Q$_{18}$) et un transistor MIS de type N (Q$_{16}$, Q$_{17}$) connectés ensemble en parallèle entre un fil de bit (BL, $\overline{BL}$) et un bus de données (DB, $\overline{DB}$) du dispositif.

3. Dispositif selon la revendication 2, dans lequel les premiers circuits élévateurs (Q$_{15}$ à Q$_{22}$) comprennent en outre des circuits d'écriture (WTC') incluant des inverseurs du type CMIS (Q$_{19}$/Q$_{20}$; Q$_{21}$/Q$_{22}$) connectés pour recevoir des signaux de sélection respectifs (IN, $\overline{IN}$) et pour appliquer les signaux de sortie respectifs aux bus de données respectifs (DB, $\overline{DB}$) du dispositif.

4. Dispositif selon l'une quelconque des revendications 1 à 3, dans lequel les premiers circuits élévateurs (Q$_{15}$ à Q$_{24}$) comprennent des transistors de charge MIS de type P (Q$_{23}$, Q$_{24}$) comportant des drains ou des sources respectives connectées au premier fil de tension d'alimentation (V$_{cc}$), des sources ou des drains respectifs connectés aus fils de bit respectifs (BL, $\overline{BL}$), et des grilles respectives connectées au deuxième fil de tension d'alimentation (V$_{ss}$).

5. Dispositif selon la revendication 1, dans lequel les premiers circuits élévateurs (Q$_{34}$ à Q$_{39}$) comprennent des portes de transfert (Q$_{34}$, Q$_{35}$) pouvant être mis en fonctionnement pour transférer des signaux respectifs aux fils de bit (BL,$\overline{BL}$) connectés à une cellule de mémoire sélectionnée (MC), quand une opération d'écriture est exécutée, chacune des portes de transfert comprenant un transistor MIS du type à enrichissement (Q$_{34}$, Q$_{35}$), ayant une tension de seuil inférieure à celle des autres transistors du type à enrichissement dans le dispositif, connecté entre un fil de bit (BL, $\overline{BL}$) et un bus de données (DB, $\overline{DB}$) du dispositif.

6. Dispositif selon la revendication 5, dans lequel les premiers circuits élévateurs (Q$_{34}$ à Q$_{39}$) comprennent en outre des circuits d'écriture (WTC'') incluant des inverseurs de type CMIS (Q$_{36}$/Q$_{37}$; Q$_{38}$/Q$_{39}$) connectés pour recevoir des signaux de sélection respectifs (IN, $\overline{IN}$) et pour appliquer les signaux de sortie respectifs aux bus de données respectifs (DB, $\overline{DB}$) du dispositif, chacun des inverseurs de type CMIS (Q$_{36}$/Q$_{37}$; Q$_{38}$/Q$_{39}$) comprenant un transistor inverseur (Q$_{37}$, Q$_{39}$) et un transistor de charge de type à épuisement (Q$_{36}$, Q$_{38}$).

7. Dispositif selon l'une quelconque des revendications 1, 5 et 6, dans lequel les premiers circuits élévateurs (Q$_{34}$ à Q$_{41}$) comprennent des transistors de charges MIS de type à épuisement (Q$_{40}$, Q$_{41}$) comportant des drains ou des sources respectives connectées au premier fil de tension d'alimentation (V$_{cc}$) et des grilles et des sources respectives, ou des grilles et des drains respectifs, connectés aux fils de bit respectifs (BL,$\overline{BL}$).

8. Dispositif selon l'une quelconque des revendications 1 à 7, comprenant en outre des circuits de commande d'adressage de ligne (RB) connectés aux fils de mot (WL) et comportant une borne de tension d'alimentation connectée aux deuxièmes circuits élévateurs (HVS), la borne de tension d'alimentation étant élevée par les deuxièmes circuits élévateurs (HVS) quand ces circuits élévateurs sont en fonctionnement.

9. Dispositif selon la revendication 8, dans lequel les deuxièmes circuits élévateurs (HVS) comprennent:

des circuits à retard (DL) comportant une borne d'entrée à laquelle est appliquée une impulsion de signal de commande ($\overline{WE}$) quand une opération d'écriture doit être exécutée, les circuits à retard pouvant être mis en fonctionnement pour produire une impulsion de signal de commande retardée ($\overline{WE}_d$) quand un temps de retard prédéterminé à partir du temps de réception de l'impulsion de signal de commande ($\overline{WE}$) s'est écoulé;

des circuits à porte ($Q_{27}$ à $Q_{30}$) connectés pour recevoir l'impulsion de signal de commande retardée ($\overline{WE}_d$) et pouvant être mis en fonctionnement, quand l'application de l'impulsion de signal de commande ($\overline{WE}$) aux circuits à retard (DL) est terminée, pour produire une impulsion de signal d'actionnement qui a une longueur égale au temps de retard; et

des circuits d'amorçage ($Q_{31}$, $C_1$) connectés pour recevoir l'impulsion de signal d'actionnement et pouvant être mis en fonctionnement, en réponse à celle-ci, pour produire une impulsion de signal de sortie ayant un potentiel qui n'est pas inférieur au potentiel du premier fil de tension d'alimentation ($V_{cc}$), la longueur de l'impulsion de signal de sortie étant égale au temps de retard.

10. Dispositif selon la revendication 9, dans lequel les deuxièmes circuits élévateurs (HVS) comprennent en outre des circuits inverseurs ($Q_{25}$, $Q_{26}$), auxquels est appliquée l'impulsion de signal de commande ($\overline{WE}$), pour inverser l'impulsion de signal de commande ($\overline{WE}$) et appliquer cette impulsion inversée (WE) aux circuits à porte ($Q_{27}$ à $Q_{30}$).

11. Dispositif selon la revendication 10, dans lequel l'impulsion de signal de commande ($\overline{WE}$) est une impulsion de signal de validation d'écriture inversée ($\overline{WE}$) et les circuits à porte ($Q_{27}$ à $Q_{30}$) comprennent une porte NI connectée pour recevoir le signal de validation d'écriture inversé retardé ($\overline{WE}_d$) provenant des circuits à retard (DL) et le signal de validation d'écriture non inversé (WE) provenant des circuits inverseurs ($Q_{25}$, $Q_{26}$).

12. Dispositif selon l'une quelconque des revendications 9 à 11, dans lequel les circuits d'amorçage ($Q_{31}$, $C_1$) comprennent un transistor MIS ($Q_{31}$), ayant sont drain et sa source connectée entre le premier fil de tension d'alimentation ($V_{cc}$) et la borne de tension d'alimentation des circuits de commande d'adressage de ligne (RB) et ayant sa grille connectée pour recevoir l'impulsion de signal d'actionnement, et un condensateur ($C_1$) connecté entre la grille et le drain du transistor ($Q_{31}$).

Fig. 1

# Fig. 2

Fig. 3

# Fig. 4

WE

WE

WEd

D        Vcc

E        Vcc

X        Vcc

IN   IN      Vcc

IN   IN

DB        Vcc

DB

BL        Vcc

BL

A        Vcc

B

Fig. 5A

Fig. 5B